# EUROPÄISCHE PATENTSCHRIFT

(11) **EP 3 296 670 B1**
(45) Veröffentlichungstag und Bekanntmachung des Hinweises auf die Patenterteilung: **15.05.2019**
(21) Anmeldenummer: 17178038.0
(22) Anmeldetag: 27.06.2017
(51) Int. Cl.: F25D 21/14

(54) **Schaltschrankkühlgerät mit einem Kondensatabscheider**
Control cabinet cooling device with a condensate separator
Appareil de refroidissement d'armoir électrique comprenant un séparateur de condensat

(30) Priorität: 15.09.2016 DE 102016117380
(43) Veröffentlichungstag der Anmeldung: 21.03.2018
(73) Patentinhaber: Rittal GmbH & Co. KG, 35745 Herborn (DE)
(72) Erfinder: Meyer, Andreas, 35460 Staufenberg (DE); Hartmann, Thomas, 35435 Krodorf-Gleiberg (DE); Becker, Dieter, 35713 Eschenburg (DE); Chmura, Sebastian, 35641 Schöffengrund (DE)
(74) Vertreter: Angerhausen, Christoph

(56) Entgegenhaltungen:
- WO-A1-2012/116724
- CN-B- 102 997 393
- JP-A- H09 207 554

## Beschreibung

Die Erfindung geht aus von einem Schaltschrankkühlgerät mit einem Gehäuse, das einen Warmlufteinlass und einen Kühlluftauslass aufweist, wobei zu kühlende Luft mit Hilfe mindestens eines Lüfters in dem Gehäuse über den Warmlufteinlass in das Gehäuse eingesogen, durch einen Luft-Kältemittel-Wärmetauscher in dem Gehäuse hindurch geleitet und über den Luftauslass als gekühlte Luft ausgeblasen ist. In Luftströmungsrichtung durch das Gehäuse dem Luft-Kältemittel-Wärmetauscher nachgeschaltet ist ein als Tropfenabscheider ausgebildeter Kondensatabscheider angeordnet. Ein derartiges Schaltschrankkühlgerät ist aus der WO 2012/116724 A1 bekannt. Die DE 37 14 727 C1 beschreibt ein Klimagerät, bei dem der Kondensatabscheider als ein Trägheitsabscheider ausgebildet ist. Ähnliche Anordnungen sind auch aus der CN 102 997 393 B und aus der JP H09 207554 A bekannt.

Die aus dem Stand der Technik bekannten Schaltschrankkühlgeräte haben den Nachteil, dass die Kondensatabführung undefiniert im Bodenbereich des Schaltschrankkühlgeräts erfolgt. Dies führt zu einer unkontrollierten Ansammlung von Kondensat im Schaltschankkühlgerät, beispielsweise in dazu vorgesehenen Kondensatauffangschalen. Darüber hinaus kommt es bei den bekannten Kondensatabscheidem vor, dass an deren kalten Außenseiten Kondensat anfällt, welches nicht über die im Inneren des Kondensatabscheiders vorgesehenen Geometrien zur Kondensatabführung erfasst wird und somit unkontrolliert am Außenumfang des Kondensatabscheiders herunterläuft und sich dementsprechend undefiniert im Bodenbereich des Schaltschrankkühlgeräts sammelt.

Es ist daher die Aufgabe der Erfindung, ein Schaltschrankkühlgerät der eingangs beschriebenen Art derart weiterzuentwickeln, dass es eine definierte Kondensatabführung bereitstellt.

Diese Aufgabe wird durch ein Schaltschrankkühlgerät mit den Merkmalen des Anspruchs 1 gelöst. Die abhängigen Ansprüche betreffen jeweils vorteilhafte Ausführungsformen der Erfindung.

Demgemäß ist vorgesehen, dass zumindest ein in Vertikalrichtung unteres Ende des Tropfenabscheiders von einer Kapselung aus einem thermischen Isolierstoff umschlossen ist, die an ihrer dem Tropfenabscheider zugewandten Seite ein Kondensatauffangreservoir aufweist, in das ein Kondensatablauf des Tropfenabscheiders mündet, wobei die Kapselung zwei parallel gegenüberliegende, vertikale Seitenwände des Tropfenabscheiders, die jeweils eine Lufteintrittsseite des Tropfenabscheiders mit einer Luftaustrittsseite des Tropfenabscheiders verbinden, im Wesentlichen über ihre gesamte Fläche bedeckt, um die Kondensatbildung an den Seitenwänden zu unterdrücken.

Der Tropfenabscheider ist vorzugsweise als ein Trägheitsabscheider ausgebildet und kann eine Mehrzahl parallel zueinander und wellenförmig verlaufender Luftleitgeometrien aufweisen, an denen die aufgrund des Luftstroms durch den Wärmetauscher am Wärmetauscher anfallenden und vom Luftstrom mitgerissenen Kondensattropfen aufgrund ihrer Massenträgheit hängenbleiben und aufgrund der Schwerkraft dem unteren Ende des Tropfenabscheiders zugleitet werden.

Die Kapselung ist aus einem thermischen Isolierstoff, beispielsweise aus einem geschäumten Isoliermaterial ausgebildet. Das Isoliermaterial kann ein Kuststoffschaum sein, beispielsweise ein PU-Schaummaterial. Der Kondensatablauf kann eine Kondensatleitung aufweisen, die in das Kondensatauffangreservoir mündet und aus dem Gehäuse herausführt.

Die Kapselung kann mindestens eine in Vertikalrichtung untere Stirnseite des Tropfenabscheiders sowie ein unteres Ende einer Luftaustrittsseite des Tropfenabscheiders umschließen, wodurch sichergestellt ist, dass das am unteren Ende des Tropfenabscheiders anfallende Kondensat sicher in das Kondensatauffangreservoir geleitet und über den Kondensatablauf abgeführt werden kann.

Um ebenso an dem Luft-Kältemittel-Wärmetauscher anfallendes Kondensat, das nicht in den Tropfenabscheider transportiert wird, sicher abzuführen, kann vorgesehen sein, dass der Luft-Kältemittel-Wärmetauscher und der Tropfenabscheider, vorzugsweise unter einem Abstand zueinander oder unmittelbar aneinander grenzend, in der Kapselung aufgenommen sind, wobei eine Lufteinlassseite des Luft-Kältemittel-Wärmetauschers in einen Lufteinlass der Kapselung und eine Luftaustrittsseite des Tropfenabscheiders in einen Luftauslass der Kapselung mündet. Die Kapselung kann eine Bodenwanne aufweisen, in die der Luft-Kältemittel-Wärmetauscher und der Tropfenabscheider eingesetzt sind, sowie Seitenpaneele, die die Seitenwände des Luft-Kältemittel-Wärmetauschers und des Tropfenabscheiders vorzugsweise vollständig bedecken, um Kondensatbildung an den Seitenwänden zu vermeiden.

Ein Lufteinlass der Kapselung kann als eine Düse und ein Luftauslass der Kapselung als ein Diffusor ausgebildet sein. Durch die Erhöhung der Geschwindigkeit, mit der die Luft den Wärmetauscher und den Kondensatabscheider durchströmt, wird einerseits erreicht, dass sämtliches in dem Wärmetauscher anfallendes Kondensat von der durchströmenden Luft mitgerissen wird und andererseits an den oben beschriebenen Luftleitgeometrien des Trägheitsabscheiders hängen bleibt, so dass die aus dem Trägheitsabscheider beziehungsweise der Kapselung austretende Luft im Wesentlichen unbelastet von Kondensattropfen ist.

Die Kapselung kann modular aufgebaut sein, mit mindestens einer Bodenwanne, in der der Tropfenabscheider über seine untere Stirnseite eingesetzt ist, und mit mindestens einem Seitenpanel, das über eine Steckverbindung mit der Bodenwanne verbunden und vorzugsweise mit dieser verklebt ist. Das Seitenpanel kann mehrere Panelkacheln aufweisen, die über eine Steckverbindung miteinander verbunden und vorzugsweise miteinander verklebt sind. Das Seitenpaneel bzw. die Paneelkacheln können die Seitenwände des Luft-Kältemittel-Wärmetauschers und des Kondensatabscheiders vollständig bedecken.

Das Gehäuse kann ein Rahmengestell mit einer rechteckigen Bodengruppe und einer rechteckigen Dachgruppe aus jeweils vier Horizontalstreben aufweisen, wie dies grundsätzlich aus der WO 2012/116724 A1 bekannt ist. Bei einer Ausführungsform ist vorgesehen, dass die Kapselung über Befestigungsaufnahmen in den Horizontalstreben an der Bodengruppe und/oder an der Dachgruppe festgelegt, insbesondere verschraubt ist.

Weitere Einzelheiten der Erfindung werden anhand der nachstehenden Figuren erläutert. Dabei zeigt:
- Figur 1: ein Kühlgerät nach dem Stand der Technik;
- Figur 2: eine Ausführungsform eines Schaltschrankkühlgeräts gemäß der vorliegenden Erfindung;
- Figur 3: eine Detailansicht des unteren Ende des Kühlgeräts gemäß Figur 2;
- Figur 4: eine schematische Darstellung einer Ausführungsform eines Schaltschrankkühlgeräts im Vertikalquerschnitt; und
- Figur 5: eine schematische Darstellung einer weiteren Ausführungsform eines Schaltschrankkühlgeräts im Horizontalquerschnitt.

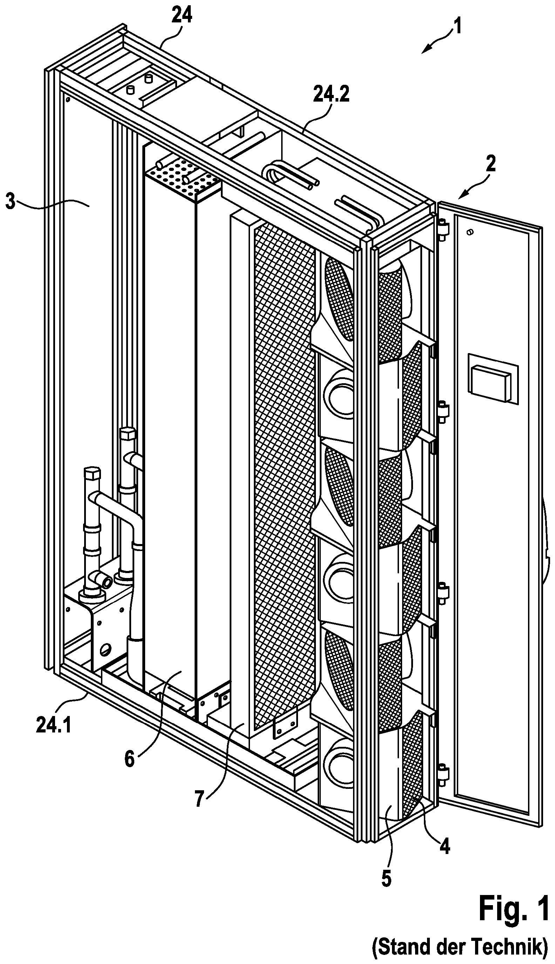

Die Figur 1 zeigt ein Schaltschrankkühlgerät 1 nach dem Stand der Technik. Dieses kann beispielsweise als ein Inline-Kühlgerät verwendet werden, das in eine Schaltschrankreihe eingereiht ist, wobei die Schaltschrankreihe einen Warmgang von einem Kaltgang abgrenzt. An der Rückseite weist das Kühlgerät 1 einen Warmlufteinlass 3 auf, über den es Warmluft aus dem Warmgang ansaugen und als gekühlte Luft über den Luftauslass 4 an der Vorderseite in den Kaltgang ausblasen kann. Für den Lufttransport sind in dem Gehäuseinneren Lüfter 5 vertikal übereinander angeordnet. Die über den Warmlufteinlass 3 angesogene Warmluft wird durch einen Luft-Kältemittel-Wärmetauscher 6 geleitet und abgekühlt. Die eventuell tropfenbeladene, abgekühlte Luft wird anschließend durch einen in Luftströmungsrichtung durch das Gehäuse 2 dem Wärmetauscher 6 nachgelagerten Tropfenabscheider 7 geleitet. Der Tropfenabscheider 7 weist ein Drahtgestrick auf, an dem Flüssigkeitstropfen, die in dem Luft-Kältemittel-Wärmetauscher 6 kondensieren und von der diesen durchströmenden Luft mitgerissen werden, hängenbleiben und somit davon abgehalten werden, in die Lüfter 5 zu geraten beziehungsweise von diesen in den Kaltgang transportiert zu werden.

Das Gehäuse 2 des Kühlgeräts 1 weist ein Rahmengestell 24 mit einer Bodengruppe 24.1 und einer Dachgruppe 24.2 auf. Mithin ist das Rahmengestell 24 aus vier Vertikal- und acht Horizontalstreben zusammengesetzt. Durch den Luft-Kältemittel-Wärmetauscher 6 wird ein Kältemittel geleitet, das über einen externen Rückkühler, beispielsweise einen Chiller, gekühlt wird, so dass die von der das Kühlgerät 1 durchströmenden Luft an den Wärmetauscher 6 abgetauschte Wärme aus dem Kühlgerät 1 beziehungsweise dem Rechenzentrum, in dem das Kühlgerät aufgestellt ist, abtransportiert werden kann.

Die aus dem Stand der Technik bekannten Kühlgeräte 1 haben den Nachteil, dass insbesondere bei hohen Luftvolumentströmen beziehungsweise hohen Luftströmungsgeschwindigkeiten nur vergleichsweise geringe Mengen des Tauwassers an dem Tropfenabscheider 7 hängenbleiben und somit wirkungsvoll dem Luftstrom entzogen werden können. Dies führt dazu, dass die Kühlgeräte mit verringertem Luftvolumenstrom beziehungsweise herabgesetzter Strömungsgeschwindigkeit betrieben werden müssen, um die über den Kühlluftauslass 4 ausgeblasene Kühlluft hinreichend von Flüssigkeitstropfen zu befreien. Um dennoch ausreichend hohe Strömungsgeschwindigkeiten und Volumenströme zu erzielen, führte dies bisher dazu, dass zur Vermeidung kritischer Zustände die Prozessluft mit Hilfe anderer Maßnahmen, die einer vergleichsweise aufwändigen Regelung bedürfen, beispielsweise einer Taupunktregelung, bei übermäßig niedriger relativer Luftfeuchtigkeit gehalten wird. Insbesondere war es erforderlich, dass die Kühlmedientemperaturen sehr genau überwacht und geregelt werden. Zur Vermeidung von Tauwasserbildung war es folglich erforderlich, dass Schwankungen der Temperaturen der Kühlmedien nach Möglichkeit vermieden wurden.

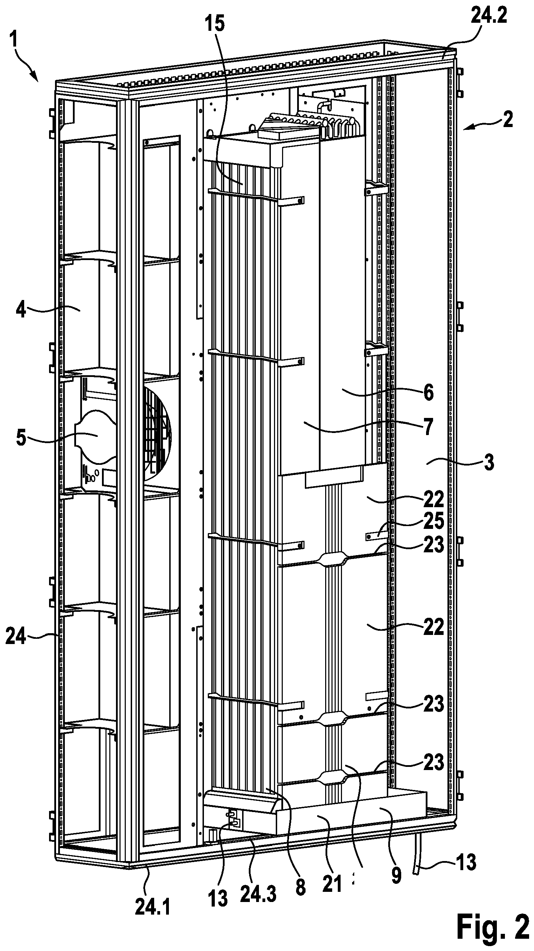

Die Figur 2 zeigt eine Ausführungsform des erfindungsgemäßen Schaltschrankkühlgeräts 1. Analog zu den aus dem Stand der Technik bekannten Kühlgeräten 1 kann dieses ein Gehäuse 2 mit einem Rahmengestell 24 aufweisen, das aus einer Bodengruppe 24.1 und einer Dachgruppe 24.2 besteht, die über vier parallele Vertikalstreben miteinander verbunden sind. In der Darstellung gemäß Figur 2 ist lediglich ein Lüfter 5 an der dem Kühlluftauslass 4 zugeordneten Vorderseite des Kühlgeräts 1 eingezeichnet. Zur Erzielung eines in Vertikalrichtung homogenen Luftvolumenstroms durch den Wärmetauscher 6 und den Tropfenabscheider 7 ist jedoch vorgesehen, dass entsprechend der Anordnung in Figur 1 in Vertikalrichtung übereinander eine Mehrzahl Lüfter 5 angeordnet sind, von denen zur Vereinfachung der Darstellung jedoch lediglich einer gezeichnet ist.

Es ist zu erkennen, dass der Wärmetauscher 6 und der Tropfenabscheider 7 über ihr unteres Ende 8 in einer Bodenwanne 21 einer Kapselung 9 stehen, so dass das untere Ende des Wärmetauschers 6 und des Tropfenabscheiders 7 zumindest teilweise innerhalb der Bodenwanne 21 aufgenommen sind. Die Bodenwanne 21 weist an gegenüberliegenden Seiten jeweils eine Kondensatleitung 13 auf, über die in der Bodenwanne 21 anfallendes Kondensat gezielt abgeführt werden kann.

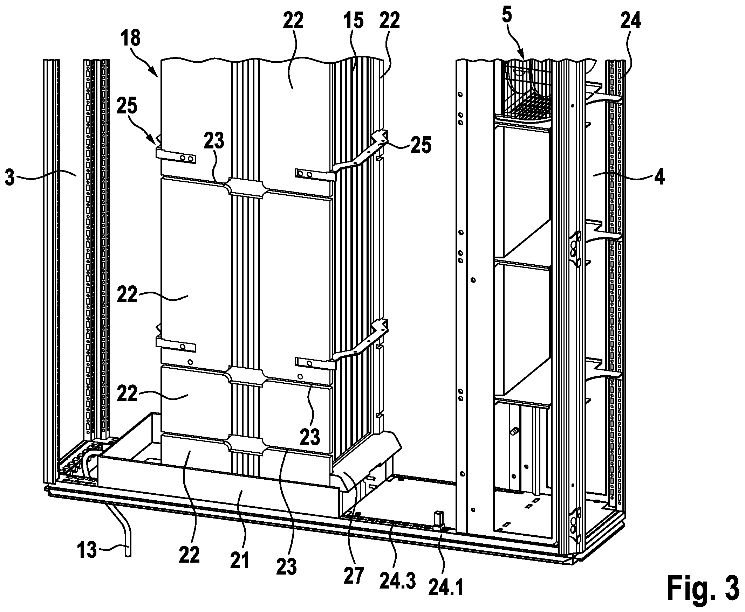

Eine Detailansicht des unteren Bereichs des Kühlgeräts 1 gemäß Figur 2 ist in Figur 3 gezeigt. Hier ist in der Zusammenschau mit der Figur 2 zu erkennen, dass an den senkrecht zu dem Warmlufteinlass 3 und dem Kühlluftauslass 4 ausgerichteten Seiten des Wärmetauschers 6 und des Tropfenabscheiders 7 jeweils ein Seitenpanel 22 angeordnet ist. Jedes Seitenpanel 22 ist aus mehreren Panelkacheln 22.1 zusammengesetzt, die über Steckverbindungen 23 miteinander verbunden und beispielsweise miteinander verklebt sein können. Um die Seitenpanelen 22 an den Wärmetauscher 6 und den Tropfenabscheider 7 festzulegen, sind die Luftaustrittsseite 15 beziehungsweise die Lufteinlassseite 18 überbrückende Halteklammern 25, welche die beiden gegenüber liegenden Seitenpanelen 22 gegeneinander festlegen, angeordnet. Eine Luftleitgeometrie 27 am unteren Ende der Luftaustrittsseite 15 hat die Funktion eines Diffusors.

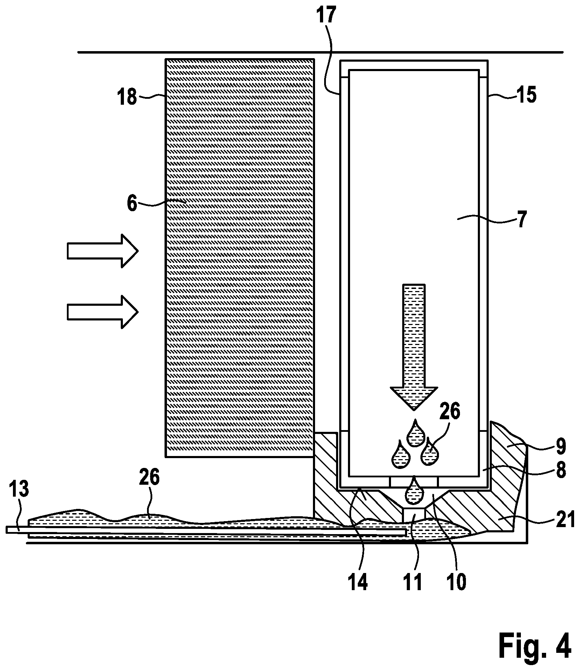

Eine weitere Ausführungsform ist in Figur 4 gezeigt. Bei dieser ist lediglich der Tropfenabscheider 7 in der Kapselung 9 aufgenommen, wobei in der Querschnittsansicht gemäß Figur 4 lediglich die Bodenwanne 21 der Kapselung 9 zu erkennen ist. Die Kapselung 9 kann entsprechend den Ausführungsformen in den Figuren 2 und 3 weiterhin gegenüber liegende Seitenpanelen 22 aufweisen. Die Seitenpanelen 22 können insbesondere aus einem thermisch isolierenden Werkstoff, beispielsweise aus einem geschäumten Kunststoff, etwa aus PU-Schaum, ausgebildet sein und so wirkungsvoll die Tauwasserbildung an den äußeren Oberflächen des Tropfenabscheiders 7 beziehungsweise bei den Ausführungsformen gemäß den Figuren 2 und 3 weiterhin an der Außenseite des Luft-Kältemittel-Wärmetauschers 6 vermeiden.

Die Ausführungsform gemäß Figur 4 zeigt anschaulich, wie der Tropfenabscheider 7 über sein unteres Ende 8 in der Bodenwanne 21 der Kapselung 9 aufgenommen ist, so dass anfallendes Kondensat, das aufgrund der Schwerkraft in Richtung des unteren Endes 8 des Tropfenabscheiders 7 gefördert wird, wirkungsvoll kanalisiert, insbesondere in das Kondensatauffangreservoir 10 der Kapselung 9 überführt werden kann. Das Kondensatauffangreservoir 10 kann beispielsweise eine nutförmige Rinne oder eine Trichtergeometrie aufweisen. Das Kondensatauffangreservoir 10 mündet in einen Kondensatablauf 11, der über eine Kondensatleitung 13 entleert ist. Die Kapselung 9 weist somit eine Doppelfunktion auf. Einmal wird durch diese gewährleistet, dass das anfallende Kondensat definiert kanalisiert werden kann und andererseits wird durch ihre thermischen Isolationseigenschaften die Kondensatbildung am Außenumfang des Tropfenabscheiders 7 verhindert, welche andernfalls ebenso einen unkontrollierten Kondensatablauf bedingen könnte.

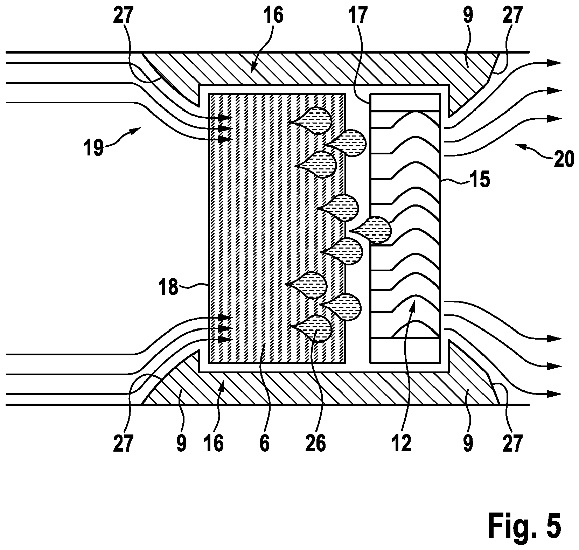

Im Vergleich zu der in Figur 4 dargestellten Ausführungsform ist bei der in Figur 5 dargestellten Ausführungsform ebenso der Luft-Kältemittel-Wärmetauscher 6 in der Kapselung 9 aufgenommen. Im Gegensatz zu Figur 4, welche eine seitliche Querschnittsansicht zeigt, zeigt Figur 5 jedoch eine horizontale Querschnittsansicht der Ausführungsform. Diese lässt jedoch erkennen, dass der Lufteinlass 19 der Kapselung 9 über eine erste Luftleitgeometrie 27 nach Art einer Düse ausgebildet ist, während der Luftauslass 20 der Kapselung 9 über eine zweite Luftleitgeometrie 27 nach Art eines Diffusors ausgebildet ist. Auf diese Weise wird erreicht, dass die Luft den Luft-Kältemittel-Wärmetauscher 6 und den Tropfenabscheider 7 mit erhöhter Geschwindigkeit durchströmt, womit einerseits effektiv sämtliches anfallendes Kondensat aus dem Luft-Kältemittel-Wärmetauscher 6 losgerissen und gleichzeitig in dem Tropfenabscheider 7 der Luft entnommen wird. Der Tropfenabscheider 7 weist wellenförmige Luftleitbelche 12 auf, an denen die von der den Tropfenabscheider 7 durchströmenden Luft mitgerissenen Flüssigkeitstropfen aufgrund ihrer Massenträgheit hängen bleiben.

### Bezugszeichenliste:

- 1: Schaltschrankkühlgerät
- 2: Gehäuse
- 3: Warmlufteinlass
- 4: Kühlluftauslass
- 5: Lüfter
- 6: Luft-Kältemittel-Wärmetauscher
- 7: Tropfenabscheider
- 8: unteres Ende
- 9: Kapselung
- 10: Kondensatauffangreservoir
- 11: Kondensatablauf
- 12: Luftleitblech
- 13: Kondensatleitung
- 14: untere Stirnseite
- 15: Luftaustrittsseite
- 16: Seitenwand
- 17: Lufteintrittsseite
- 18: Lufteinlassseite
- 19: Lufteinlass
- 20: Luftauslass
- 21: Bodenwanne
- 22: Seitenpanel
- 22.1: Panelkachel
- 23: Steckverbindung
- 24: Rahmengestell
- 24.1: Bodengruppe
- 24.2: Dachgruppe
- 24.3: Befestigungsaufnahme
- 25: Halteklammer
- 26: Kondensat
- 27: Luftleitgeometrie

## Patentansprüche

1. Schaltschrankkühlgerät (1) mit einem Gehäuse (2), das einen Warmlufteinlass (3) und einen Kühlluftauslass (4) aufweist, wobei zu kühlende Luft mithilfe mindestens eines Lüfters (5) in dem Gehäuse (2) über den Warmlufteinlass (3) in das Gehäuse (2) eingesogen, durch einen Luft-Kältemittel-Wärmetauscher (6) in dem Gehäuse (2) hindurch geleitet und über den Kühlluftauslass (4) als gekühlte Luft ausgeblasen ist, wobei in Luftströmungsrichtung durch das Gehäuse (2) dem Luft-Kältemittel-Wärmetauscher (6) nachgeschaltet ein Tropfenabscheider (7) angeordnet ist, **dadurch gekennzeichnet, dass** zumindest ein in Vertikalrichtung unteres Ende (8) des Tropfenabscheiders (7) von einer Kapselung (9) aus einem thermischen Isolierstoff umschlossen ist, die an ihrer dem Tropfenabscheider (7) zugewandten Seite ein Kondensatauffangreservoir (10) aufweist, in das ein Kondensatablauf (11) des Tropfenabscheiders (7) mündet, wobei die Kapselung (9) zwei parallel gegenüberliegende, vertikale Seitenwände (16) des Tropfenabscheiders (7), die jeweils eine Lufteintrittsseite (17) des Tropfenabscheiders (7) mit einer Luftaustrittsseite (15) des Tropfenabscheiders (7) verbinden, im Wesentlichen über ihre gesamte Fläche bedeckt.

2. Schaltschrankkühlgerät (1) nach Anspruch 1, bei dem der Kondensatablauf (11) eine Kondensatleitung aufweist, die in das Kondensatauffangreservoir (10) mündet und aus dem Gehäuse (2) herausführt.

3. Schaltschrankkühlgerät (1) nach Anspruch 1 oder 2, bei dem die Kapselung (9) zumindest eine in Vertikalrichtung untere Stirnseite (14) des Tropfenabscheiders (7) sowie ein unteres Ende einer Luftaustrittsseite (15) des Tropfenabscheiders (7) umschließt.

4. Schaltschrankkühlgerät (1) nach einem der vorangegangenen Ansprüche, bei dem die Kapselung (9) aus einem geschäumten thermischen Isolierstoff, insbesondere aus einem Kunststoffschaum, ausgebildet ist.

5. Schaltschrankkühlgerät (1) nach einem der vorangegangenen Ansprüche, bei dem der Luft-Kältemittel-Wärmetauscher (6) und der Tropfenabscheider (7) unter einem Abstand zueinander oder unmittelbar aneinander grenzend in der Kapselung (9) aufgenommen sind, wobei eine Lufteinlassseite (18) des Luft-Kältemittel-Wärmetauschers (6) in einen Lufteinlass (19) der Kapselung (9) und eine Luftaustrittsseite (15) des Tropfenabscheiders (7) in einen Luftauslass (20) der Kapselung (9) mündet.

6. Schaltschrankkühlgerät (1) nach einem der vorangegangenen Ansprüche, bei dem ein Lufteinlass (19) der Kapselung (9) als eine Düse und ein Luftauslass (20) der Kapselung (9) als Diffusor ausgebildet ist.

7. Schaltschrankkühlgerät (1) nach einem der vorangegangenen Ansprüche, bei dem die Kapselung (9) modular aufgebaut ist, mindestens mit einer Bodenwanne (21), in der der Tropfenabscheider (7) über seine untere Stirnseite (14) eingesetzt ist, und mit mindestens einem Seitenpaneel (22), das über eine Steckverbindung (23) mit der Bodenwanne (21) verbunden und vorzugsweise mit dieser verklebt ist.

8. Schaltschrankkühlgerät (1) nach Anspruch 7, bei dem das Seitenpaneel (22) mehrere Panelkacheln (22.1) aufweist, die über eine Steckverbindung (23) miteinander verbunden und vorzugsweise miteinander verklebt sind.

9. Schaltschrankkühlgerät (1) nach einem der vorangegangenen Ansprüche, bei dem das Gehäuse (2) ein Rahmengestell (24) mit einer rechteckigen Bodengruppe (24.1) und einer rechteckigen Dachgruppe (24.2) aus jeweils vier Horizontalstreben aufweist, wobei die Kapselung (9) über Befestigungsaufnahmen (24.3) in den Horizontalstreben an der Bodengruppe (24.1) und/oder an der Dachgruppe (24.2) festgelegt ist.

## Claims

1. A control cabinet cooling device (1) with a housing (2) which comprises a hot air inlet (3) and a cooling air outlet (4), wherein the air to be cooled is suctioned by means of at least one fan (5) in the housing (2) via the hot air inlet (3) into the housing (2), led through an air-refrigerant heat exchanger (6) in the housing (2) and blown out as cooled air via the cooling air outlet (4), wherein a droplet separator (7) is arranged downstream of the air-refrigerant heat exchanger (6) in the air flow direction through the housing (2), **characterized in that** at least one lower end (8) of the droplet separator (7) in vertical direction is enclosed by an encapsulation (9) formed from a thermal insulation material, which, on the side thereof facing the droplet separator (7), comprises a condensate collection reservoir (10), into which a condensate discharge (11) of the droplet separator (7) leads, wherein the encapsulation (9) substantially covers the entire surface of two vertical side walls (16) of the droplet separator (7), which face one another in parallel, and which in each case connect an air inlet side (17) of the droplet separator (7) to an air outlet side (15) of the droplet separator (7).

2. The control cabinet cooling device (1) according to Claim 1, in which the condensate discharge (11) comprises a condensate line which leads into the condensate collection reservoir (10) and out of the housing (2).

3. The control cabinet cooling device (1) according to Claim 1 or 2, in which the encapsulation (9) includes at least one lower front side (14) of the droplet separator (7) in vertical direction as well as a lower end of an air outlet side (15) of the droplet separator (7).

4. The control cabinet cooling device (1) according to any one of the preceding claims, in which the encapsulation (9) is formed from a foamed thermal insulation material, in particular from a plastic foam.

5. The control cabinet cooling device (1) according to any one of the preceding claims, in which the air-refrigerant heat exchanger (6) and the droplet separator (7) are accommodated, spaced apart from one another or immediately adjoining one another, in the encapsulation (9), wherein an air inlet side (18) of the air-refrigerant heat exchanger (6) leads into an air inlet (19) of the encapsulation (9), and an air outlet side (15) of the droplet separator (7) leads into an air outlet (20) of the encapsulation (9).

6. The control cabinet cooling device (1) according to any one of the preceding claims, in which an air inlet (19) of the encapsulation (9) is formed as a nozzle, and an air outlet (20) of the encapsulation (9) is formed as a diffuser.

7. The control cabinet cooling device (1) according to any one of the preceding claims, in which the encapsulation (9) has a modular structure, with at least one bottom tray (21) in which the droplet separator (7) is inserted via the lower front side (14) thereof, and with at least one side panel (22) which is connected via a plug-in connector (23) to the bottom tray (21) and preferably bonded thereto.

8. The control cabinet cooling device (1) according to Claim 7, in which the side panel (22) comprises several panel tiles (22.1) which are connected to one another via a plug-in connector (23) and preferably bonded to one another.

9. The control cabinet cooling device (1) according to any one of the preceding claims, in which the housing (2) comprises a rack (24) with a rectangular bottom group (24.1) and a rectangular roof group (24.2) each consisting of four horizontal struts, wherein the encapsulation (9) is fixed via fastening recesses (24.3) in the horizontal struts on the bottom group (24.1) and/or on the roof group (24.2).

## Revendications

1. Appareil de refroidissement d'armoire électrique (1) avec un carter (2), qui comprend une admission d'air chaud (3) et une évacuation d'air froid (4), de l'air à refroidir étant aspiré vers le carter (2) par le biais de l'admission d'air chaud (3) au moyen d'au moins un ventilateur (5) dans le carter (2), conduit à travers un échangeur de chaleur air-réfrigérant (6) situé dans le carter (2) et expulsé en tant qu'air refroidi par le biais de l'évacuation d'air froid (4), un séparateur de gouttes (7) étant disposé en aval dans l'échangeur de chaleur air-réfrigérant (6) dans la direction d'écoulement de l'air à travers le carter (2), **caractérisé en ce qu'**au moins une extrémité (8) du séparateur de gouttes (7) inférieure dans la direction verticale est entourée d'un encapsulage (9) en matériau thermiquement isolant qui comporte, sur son côté tourné vers le séparateur de gouttes (7), un réservoir de récupération des condensats (10) dans lequel débouche un déversement des condensats (11) du séparateur de gouttes (7), l'encapsulage (9) couvrant essentiellement sur toute sa surface deux parois latérales (16) verticales opposées en parallèle du séparateur de gouttes (7) qui raccordent respectivement un côté d'entrée d'air (17) du séparateur de gouttes (7) à un côté de sortie d'air (15) du séparateur de gouttes (7).

2. Appareil de refroidissement d'armoire électrique (1) selon la revendication 1, dans lequel le déversement des condensats (11) comporte une conduite des condensats qui débouche dans le réservoir de récupération des condensats (10) et conduit hors du carter (2).

3. Appareil de refroidissement d'armoire électrique (1) selon la revendication 1 ou 2, dans lequel l'encapsulage (9) entoure au moins un côté frontal (14), inférieur dans la direction verticale, du séparateur de gouttes (7) ainsi qu'une extrémité inférieure d'un côté de sortie d'air (15) du séparateur de gouttes (7).

4. Appareil de refroidissement d'armoire électrique (1) selon l'une des revendications précédentes, dans lequel l'encapsulage (9) est constitué d'un matériau thermiquement isolant expansé, en particulier en mousse de matière plastique.

5. Appareil de refroidissement d'armoire électrique (1) selon l'une des revendications précédentes, dans lequel l'échangeur de chaleur air-réfrigérant (6) et le séparateur de gouttes (7) sont reçus dans l'encapsulage (9) avec un espace entre eux ou de façon directement contiguë l'un avec l'autre, un côté d'admission d'air (18) de l'échangeur de chaleur air-réfrigérant (6) débouchant dans une admission d'air (19) de l'encapsulage (9), et un côté sortie d'air (15) du séparateur de gouttes (7) débouchant dans une évacuation d'air (20) de l'encapsulage (9).

6. Appareil de refroidissement d'armoire électrique (1) selon l'une des revendications précédentes, dans lequel une admission d'air (19) de l'encapsulage (9) est constituée en tant que buse, et une évacuation d'air (20) de l'encapsulage (9) est constituée en tant que diffuseur.

7. Appareil de refroidissement d'armoire électrique (1) selon l'une des revendications précédentes, dans lequel l'encapsulage (9) est constitué de façon modulaire, au moins avec une cuvette de fond (21) dans laquelle le séparateur de gouttes (7) est introduit par le biais de son côté frontal (14) inférieur, et avec au moins un panneau latéral (22) qui est raccordé par le biais d'une connexion enfichable (23) à la cuvette de fond (21) et est préférence assemblé à celle-ci par collage.

8. Appareil de refroidissement d'armoire électrique (1) selon la revendication 7, dans lequel le panneau latéral (22) comporte plusieurs carreaux de panneau (22.1) qui sont raccordés les uns aux autres par le biais d'une connexion enfichable (23) et sont assemblés les uns aux autres par collage.

9. Appareil de refroidissement d'armoire électrique (1) selon l'une des revendications précédentes, dans lequel le carter (2) comporte un bâti de cadre (24) avec un groupe de fond (24.1) rectangulaire et un groupe de toit (24.2) rectangulaire comprenant respectivement quatre entretoises horizontales, l'encapsulage (9) étant par le biais de logements de fixation (24.3) immobilisé dans les entretoises horizontales sur le groupe de fond (24.1) et/ou sur le groupe de toit (24.2).
